Europäisches Patentamt

European Patent Office

Office européen des brevets

(11) Numéro de publication: **0 021 916**

**A1**

(12)

# DEMANDE DE BREVET EUROPEEN

(21) Numéro de dépôt: **80400799.5**

(22) Date de dépôt: **04.06.80**

(51) Int. Cl.³: **G 01 R 15/02**
G 01 R 31/02, B 60 Q 11/00
**G 01 R 19/165**

(30) Priorité: **06.06.79 FR 7914453**

(43) Date de publication de la demande:
**07.01.81 Bulletin 81/1**

(84) Etats Contractants Désignés:
**CH DE GB LI SE**

(71) Demandeur: **COMMISSARIAT A L'ENERGIE ATOMIQUE
Etablissement de Caractère Scientifique Technique et
Industriel
B.P. 510
F-75752 Paris Cedex 15(FR)**

(72) Inventeur: **Delapierre, Gilles
216 Percevalière
F-38170 Seyssinet(FR)**

(74) Mandataire: **Mongredien, André et al,
c/o Brevatome 25, rue de Ponthieu
F-75008 Paris(FR)**

(54) **Procédé de surveillance de l'état instantané d'un circuit électrique et notamment de détection d'une rupture de ce circuit.**

(57) On dispose une partie du trajet d'un conducteur du circuit au voisinage de deux couches magnétiques minces orientées et on effectue une détection différentielle des variations de la résistance des dites couches magnetiques ou "magnétorésistances".

Application à la surveillance du bon fonctionnement des lampes électriques d'automobiles.

EP 0 021 916 A1

La présente invention a trait à la surveillance de l'état instantané d'un circuit électrique qui est susceptible de fonctionner dans une plage limitée à deux états, à savoir : un état normal qui correspond au passage dans un conducteur déterminé d'une intensité sensiblement nominale et un état critique, ou de seuil, correspondant au passage dans ledit conducteur d'une intensité électrique dite de seuil. Elle s'applique plus particulièrement au cas où l'intensité de seuil est nulle et correspond à la coupure du conducteur. Dans ce cas particulier, le procédé objet de l'invention, se comporte alors comme un procédé de détection et de signalisation de la rupture d'un circuit électrique alimenté en courant continu ou alternatif. Une application particulièrement intéressante d'un procédé de ce genre réside dans la détection de rupture des filaments de lampes électriques situées à bord d'un véhicule automobile. Dans la suite du présent texte, on fera surtout référence à cette application qui est l'une des principales de l'invention, étant bien entendu que ceci n'est pas limitatif et que beaucoup d'autres circuits peuvent être surveillés de la même façon.

On a déjà utilisé dans la technique automobile différents systèmes pour déceler le plus rapidement possible la défaillance de l'une des lampes électriques constituant l'équipement d'un véhicule. Les systèmes actuellement connus consistent à mesurer soit les variations de la tension électrique aux bornes d'une résistance insérée en série dans le circuit d'alimentation d'une lampe à surveiller, soit la variation de la perméabilité d'un matériau magnétique sous l'effet du champ magnétique créé par le courant électrique parcourant l'un des conducteurs du circuit précédent.

Le premier système nécessite l'insertion dans le circuit d'une ou plusieurs résistances de valeur parfaitement contrôlée, suffisamment faible pour ne pas dissiper trop de puissance et suffisamment élevée pour donner néanmoins un signal utilisable. Les systèmes de ce type ont généralement pour inconvénient majeur de ne pas supporter les court-circuits de l'organe à surveiller, la résistance insérée jouant alors le rôle de fusible. Ceci est un inconvénient grave, car à chaque fois qu'apparaît une surcharge en intensité du circuit surveillé, il faut envisager, en plus du changement de l'organe responsable de la surcharge, le changement des résistances de surveillance qui du fait de leur grande précision requise ne peuvent être des produits standard de faible prix de revient.

Le système reposant sur la variation de la perméabilité magnétique d'une sonde présente quant à lui, l'inconvénient de nécessiter un signal d'excitation en courant alternatif qu'il faut donc engendrer spécialement car un tel courant n'existe pas nécessairement sur toutes les voitures automobiles. Ces systèmes sont de plus constitués généralement d'un matériau magnétique massif, auquel on a donné la forme d'un tore ayant une courbe d'aimantation bien contrôlée et sur lequel on réalise un ou plusieurs bobinages. Ils sont donc relativement encombrants, et assez rapidement coûteux, surtout dans le cas où il y a de nombreux organes à contrôler comme cela se produit sur un véhicule automobile où il existe facilement une dizaine de lampes électriques au total.

La présente invention a pour objet un procédé de surveillance de l'état instantané d'un circuit électrique qui résout de façon simple et peu coûteuse les problèmes précédents. A cette fin, l'invention utilise un dispositif à magnétorésistances placées au voisinage d'un conducteur parcouru par le courant à surveiller.

On connaît déjà des techniques qui utilisent de tels moyens. Ces techniques sont décrites notamment dans :

- le brevet américain 2 946 955 du 26 juillet 1960 intitulé "Measuring Apparatus comprising a magnetic field-responsive resistor as a condition-responsive element",

- l'article de K.H. KNICKMEYER, publié dans la revue I.B.M. Technical Disclosure Bulletin, vol. 18,

B 6672-3 AM

N° 8, Janvier 1976, p. 2565, et intitulé "Magnetoresistive Detection Apparatus".

Le dispositif décrit dans le brevet américain cité utilise l'effet Hall ou la magnétorésistance des semiconducteurs du groupe des III-V bien connus pour la forte mobilité de leurs porteurs (70 000 $cm^2$/Vs) et donc leurs bonnes qualités en tant que détecteurs magnétosensibles. Cependant, si l'on considère qu'à 1 mm de l'axe d'un conducteur parcouru par un courant de 1A, le champ est de 2 Oe, le signal le plus grand que l'on puisse espérer avec le capteur le plus sensible du type décrit dans ce brevet (type SV 130/I) est de 0,35 mV. C'est un signal très faible et de plus il constitue une limite supérieure, car la plus petite dimension du capteur étant de 4 mm, celui-ci ne pourra pas être placé à 1 mm du conducteur. De plus, les matériaux utilisés sont très sensibles à la température et aucune solution n'est proposée pour résoudre ce problème. En ce qui concerne les champs parasites, ils seront entièrement pris en compte par le dispositif et apparaîtront comme l'équivalent d'un courant. Ces problèmes limitent le champ d'application de tels dispositifs aux forts courants, comme par exemple ceux des cuves à électrolyse.

Le système décrit dans la revue I.B.M. utilise deux magnétorésistances au moins pour mesurer un seul courant. Dans le cas de la surveillance de quatre ampoules de véhicule par exemple, il faut quatre ponts et quatre amplificateurs. En outre, la structure décrite ne permet pas de s'affranchir de l'influence des champs parasites. En effet, tout champ superposé au champ créé par le courant à mesurer, notamment le champ terrestre, ne pourra être distingué du champ à mesurer. Enfin, la compensation en température est obtenue au prix d'une grande complication. Pour cela, il est fait usage de deux magnétorésistances qui varient de la même façon en fonction de la température, mais en sens opposés en fonction du champ appliqué. Or, la magnétorésistance n'est sensible qu'à l'amplitude du champ et non à son sens. Pour obtenir une variation de résistance qui dépende du sens du champ, on doit appliquer un champ de polarisation qui corresponde à une rotation de l'aimantation de 45°. La réponse du capteur sera donc très liée à la stabilité du point de polarisation. Or, si l'on veut conserver une sensibilité importante, le champ de polarisation sera forcément du même ordre de grandeur que le champ à mesurer et donc que le champ terrestre dans certains cas. Un tel système ne peut pas être utilisé en dehors de blindages soignés et donc coûteux.

L'invention a pour objet un procédé qui évite tous ces inconvénients. Pour cela, on procède par comparaison différentielle entre l'influence du courant à surveiller sur une magnétorésistance et l'influence d'un courant de référence sur une autre magnétorésistance. Chacune des magnétorésistances réagit de façon identique à la température et aux champs extérieurs. La seule cause possible de déséquilibre du dispositif est donc la rupture de l'un des courants. Ceci est particulièrement avantageux dans la surveillance des ampoules de véhicule où chaque lampe sert de référence à sa symétrique.

De façon plus précise, la présente invention a pour objet un procédé de surveillance de l'état instantané d'un circuit électrique devant fonctionner dans une plage limitée à deux états, à savoir un état normal correspondant au passage dans un conducteur d'une intensité nominale et un état critique ou de seuil correspondant au passage dans ledit conducteur d'une intensité de seuil, notamment d'une intensité nulle, utilisant la détection des variations éventuelles de la résistance d'une couche magnétique ou "magnétorésistance" sous l'influence du champ magnétique dû à l'intensité du courant électrique circulant dans un

B 6672-3 AM

conducteur dont une partie du trajet est disposée au voisinage d'au moins une couche magnétique mince orientée, caractérisé en ce que ladite détection est effectuée à l'aide d'une mesure différentielle de la magnétorésistance d'au moins deux couches magnétiques distinctes voisines dont l'une subit le champ du circuit à surveiller et l'autre le champ d'un courant de référence, les circuits et les couches étant disposés de façon à s'affranchir des variations de magnétorésistance dues aux variations ambiantes de température et/ou de champ magnétique.

Le procédé selon l'invention utilise par exemple la magnétorésistance de couches minces de Fe Ni déposées sous vide. De telles couches, évaporées en présence d'un champ magnétique de quelques Oersteds présentent ensuite, de façon permanente, une direction dite de facile aimantation, parallèle à ce champ. Ceci signifie qu'en l'absence de tout champ extérieur, l'aimantation de la couche est parallèle à cette direction. Si, au contraire, l'on applique à cette couche un champ extérieur Ha perpendiculairement à cette direction, l'aimantation tourne d'un angle θ tel que :

$$\sin \theta = Ha/Hk \quad si \quad Ha < Hk$$
$$\sin \theta = 1 \qquad si \quad Ha > Hk$$

où Hk est le champ dit d'anisotropie.

Selon les conditions de préparation, Hk peut varier couramment de 1,5 à 5 Oe ou plus. Pour les applications courantes du procédé, objet de l'invention, le champ Hk est de préférence choisi égal à 2 Oe.

Le phénomène physique intéressant pour l'invention est que cette rotation de l'aimantation s'accompagne d'une variation Δρ de la résistivité ρ du matériau selon la loi

$$\Delta\rho = \Delta\rho_{max} \cos^2 \theta$$

ρ étant maximal pour Ha = 0.

Pour une couche de FeNi, on aura typiquement

$$\frac{\Delta\rho_{max}}{\rho} \approx 3\ \%.$$

Si l'on place une telle couche mince à 1 mm du

B 6672-3 AM

centre d'un conducteur parcouru par un courant d'intensité I mesurée en Ampères, le champ magnétique appliqué Ha sera d'environ 2 Oe/A. On obtient donc $\Delta\rho \approx \Delta\rho_{max}$ pour un courant de 1A environ, ordre de grandeur intéressant pour de nombreuses applications. Si la magnétorésistance fait par exemple 100 $\Omega$ (valeur très facile à obtenir), on obtient pour un courant de polarisation de 20 mA (puissance dissipée 40 mW) un $\Delta V_{max} = I.\Delta R \approx 60$ mV. Une telle valeur est très supérieure au minimum nécessaire pour commander un circuit comparateur, même à très bas prix.

On peut également affecter chacune des différentes couches minces à la surveillance d'un circuit particulier, ce qui permet, tout en conservant les avantages des mesures différentielles, d'effectuer simultanément la surveillance de deux ou d'un nombre pair de circuits. Un cas particulièrement intéressant d'applications de cette variante du procédé consiste à utiliser quatre couches minces magnétiques orientées, disposées selon les quatre branches d'un pont de Wheatstone, chacune desdites quatre branches assurant alors la surveillance d'un circuit électrique particulier. Les éléments constitutifs et d'alimentation du pont de Wheatstone sont alors réglés pour que le pont soit équilibré lorsque les circuits à surveiller sont parcourus par leur intensité nominale, et le passage dans l'un des circuits quelconques de cette intensité nominale à une intensité de seuil, pouvant être nulle dans le cas où l'on souhaite repérer une rupture, provoque un déséquilibre du pont qu'il suffit de détecter. Pour ce faire, on peut employer toute méthode connue à la portée de l'Homme de l'Art ; il est toutefois avantageux d'utiliser selon l'invention, deux comparateurs à sortie logique dont chacun a l'une de ses entrées reliées aux sorties à surveiller du pont de Wheatstone, les deux sorties desdits comparateurs alimentant l'entrée d'un circuit "OU" qui délivre lui-même un signal en sortie si, par suite du déséquilibre du pont, l'un des comparateurs délivre un signal en sortie.

Une application très intéressante du procédé objet de l'invention est la détection des ruptures des circuits d'alimentation des lampes de véhicules automobiles. Si l'on remarque en effet, que sur un tel véhicule, les lampes fonctionnent presque toujours par groupes de deux, alors qu'elles ne défaillent que par une à la fois, on peut, grâce à une seule mesure différentielle à l'aide d'un pont de Wheatstone, contrôler deux ou quatre lampes à la fois, voire même six ou huit lampes. La structure en pont de Wheatstone présente d'autre part l'avantage de compenser automatiquement toute variation de $\rho$ due à la température et/ou au champ magnétique ambiant, puisque les magnétorésistances réalisées en même temps sur le même substrat, varient de la même façon.

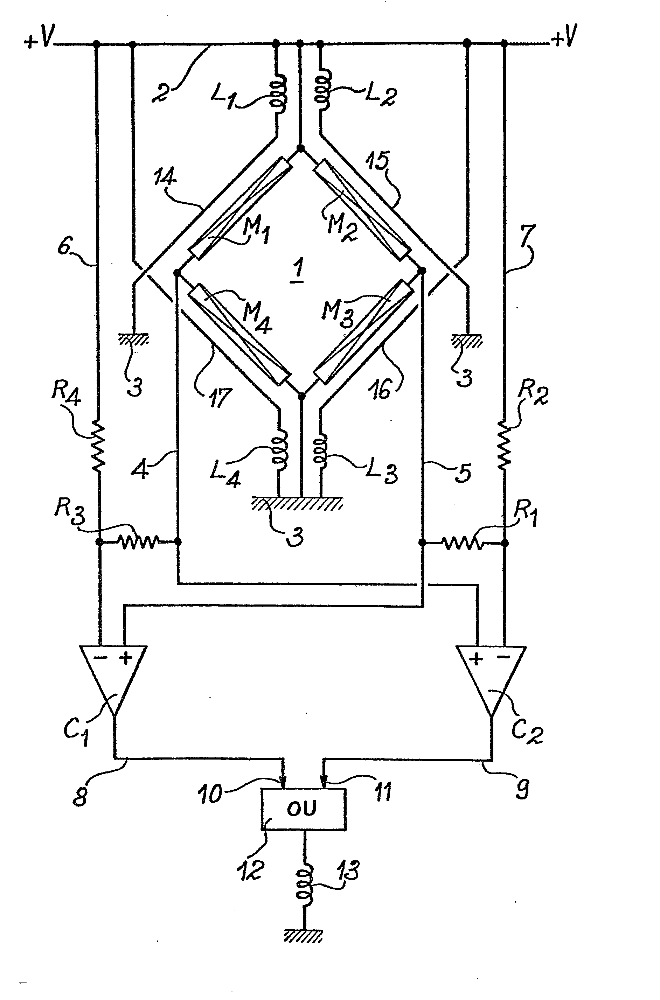

De toute façon, l'invention sera mieux comprise à la lecture de la description qui suit, d'un exemple de mise en oeuvre du procédé de surveillance de l'état d'un circuit, description qui sera faite en se référant à la figure unique, laquelle représente un schéma de montage électrique possible pour la mise en oeuvre du procédé en vue de la surveillance de l'état de coupure éventuelle des circuits d'alimentation des lampes électriques d'une voiture automobile.

Le pont de Wheatstone portant sur le dessin la référence générale 1, comporte quatre magnétorésistances $M_1$, $M_2$, $M_3$ et $M_4$ égales deux à deux, c'est-à-dire pour lesquelles $M_1 = M_2$ et $M_3 = M_4$ ou plus généralement telles que $M_1 M_3 = M_2 M_4$. Ce pont de Wheatstone est alimenté entre l'anode 2 portée à la tension +V et la masse. L'état d'équilibre ou de déséquilibre du pont est donc, de façon classique, mesuré entre les conducteurs de sortie 4 et 5

B 6672-3 AM

aboutissant à la diagonale opposée du pont de Wheatstone.
Sur la figure unique, on a représenté quatre lampes $L_1$, $L_2$, $L_3$ et $L_4$ appartenant au même véhicule automobile et qui sont alimentées chacune séparément entre le conducteur 2 porté au potentiel +V et la masse 3. Sur un véhicule automobile courant, les lampes électriques sont généralement réparties par paires de lampes identiques correspondant l'une au côté droit et l'autre au côté gauche du véhicule. Il en résulte par conséquent qu'il est relativement facile d'équilibrer un tel pont de Wheatstone en groupant les lampes $L_1$ et $L_4$ correspondant au côté gauche et $L_2$ et $L_3$ correspondant au côté droit du véhicule symétriquement par rapport aux quatre banches du pont. Quoi qu'il en soit quatre résistances $R_1$, $R_2$, $R_3$ et $R_4$ permettent d'assurer une polarisation convenable des deux entrées négatives des comparateurs logiques $C_1$ et $C_2$ de façon à ce que ceux-ci, dont la borne positive est alimentée par l'un des conducteurs 4 ou 5 en provenance du pont de Wheatstone, délivrent en sortie un signal nul lorsque le pont est à l'équilibre. A cet effet, la résistance $R_4$ est située sur le conducteur 6 qui relie l'entrée négative du comparateur $C_1$ à la borne 2 et la résistance $R_2$ est située sur le conducteur 7 qui relie l'entrée négative du comparateur $C_2$ à la même borne 2. Une résistance $R_3$ relie les conducteurs 4 et 6 et une résistance $R_1$ relie les conducteurs 5 et 7.

La sortie 8 du comparateur $C_1$ et la sortie 9 du comparateur $C_2$ sont reliées respectivement à l'entrée 10 et à l'entrée 11 du circuit "OU" 12. La sortie 13 de ce circuit "OU" est donc à zéro si aucun signal logique n'apparaît sur les sorties 8 et 9 des comparateurs $C_1$ et $C_2$; elle délivre au contraire un signal 1 si l'une des deux voies 8 ou 9 délivre elle-même un signal égal à 1.

Chacun des conducteurs 14, 15, 16 et 17 des circuits d'alimentation de lampes $L_1$, $L_2$, $L_3$ et $L_4$ est situé

B 6672-3 AM

au voisinage immédiat de l'une des quatre magnétorésistances, à savoir ici $M_1$, $M_2$, $M_3$ et $M_4$, de façon que celles-ci puissent être continuellement sous la dépendance du champ magnétique créé par le courant qui circule dans chacune de ces lampes. Le pont 1 est réglé pour être à l'équilibre en l'absence de tout courant dans les lampes $L_1$, $L_2$, $L_3$ et $L_4$. Lorsque les lampes $L_1$ et $L_2$ et/ou $L_3$ et $L_4$ sont allumées, le pont reste à l'équilibre puisqu'on conserve l'égalité $M_1M_3 = M_2M_4$, soit parce que les courants sont égaux dans $L_1$ et $L_2$ et/ou dans $L_3$ et $L_4$, soit parce qu'ils sont inégaux, mais suffisants pour donner Ha > Hk. En revanche, si l'une quelconque des lampes est hors d'usage, le pont 1 est déséquilibré, la sortie de $C_1$ ou $C_2$ passe à l'état "1", et l'alarme est déclenchée.

Le système a été décrit pour deux ou quatre lampes, mais de nombreuses combinaisons permettent de passer à six ou huit ou même plus. On peut ainsi, soit diviser chaque magnétorésistance en deux magnétorésistances en parallèle ou en série, soit faire passer deux conducteurs devant la même magnétorésistance.

Dans ce dernier cas, on s'arrange avantageusement pour que la somme des champs créés par les deux courants, si possible voisins, donne $\theta \simeq 90°$ ou mieux $\theta \simeq 0°$ avec deux courants égaux et opposés. On peut également jouer sur la largeur de la magnétorésistance et donc le champ démagnétisant s'opposant au champ appliqué pour ajuster la valeur du champ donnant $\Delta\rho_{max}$.

La description précédente a été faite pour un circuit à courant continu, mais le dispositif peut également très bien être utilisé en cas de besoin dans le cas de courants alternatifs ; on obtient alors à la sortie des comparateurs $C_1$ et $C_2$, en cas de rupture d'un des conducteurs 14, 15, 16 et 17, un signal alternatif qui peut alimenter un voyant par exemple.

B 6672-3 AM

On voit donc qu'avec un système extrêmement simple, constitué d'une couche mince et d'un circuit intégré du commerce parmi les plus répandus, on réalise un détecteur assurant la surveillance de huit appareils à la fois. Ce dispositif peut, de plus, être installé sur un circuit déjà en service. Dans une réalisation pratique du détecteur, on peut par exemple rapporter directement sur la couche mince la puce du circuit intégré de détection différentielle.

REVENDICATIONS

1. Procédé de surveillance de l'état instantané d'un circuit électrique devant fonctionner dans une plage limitée à deux états, à savoir un état normal correspondant au passage dans un conducteur d'une intensité nominale et un état critique ou de seuil correspondant au passage dans ledit conducteur d'une intensité de seuil, notamment d'une intensité nulle, utilisant la détection des variations éventuelles de la résistance d'une couche magnétique ou "magnétorésistance" sous l'influence du champ magnétique dû à l'intensité du courant électrique circulant dans un conducteur dont une partie du trajet est disposée au voisinage d'au moins une couche magnétique mince orientée, caractérisé en ce que ladite détection est effectuée à l'aide d'une mesure différentielle de la magnétorésistance d'au moins deux couches magnétiques distinctes voisines dont l'une subit le champ du circuit à surveiller et l'autre le champ d'un courant de référence, les circuits et les couches étant disposés de façon à s'affranchir des variations de magnétorésistance dues aux variations ambiantes de température et/ou de champ magnétique.

2. Procédé selon la revendication 1, caractérisé en ce que les différentes couches minces utilisées sont affectées chacune à la surveillance d'un circuit particulier.

3. Procédé selon l'une quelconque des revendications 1 et 2, caractérisé en ce que la mesure différentielle est effectuée à l'aide d'un pont de Wheatstone dont au moins une branche est constituée par une couche magnétique mince orientée qui subit le champ magnétique d'un courant de référence et dont chacune des autres branches, constituée d'une couche magnétique mince orientée, assure la surveillance d'un circuit électrique particulier.

4. Procédé selon la revendication 3, caractérisé en ce que les deux sorties à surveiller du pont de Wheatstone sont reliées chacune à un comparateur à sortie logique, les deux sorties desdits comparateurs alimentant l'entrée

B 6672.3 AM

0021916

d'un circuit "OU" qui délivre lui-même un signal en sortie lorsque le pont est déséquilibré.

5. Procédé selon l'une quelconque des revendications 1 à 4, caractérisé en ce qu'au moins l'une des couches minces est associée à au moins deux conducteurs à surveiller.

6. Procédé selon la revendication 5, caractérisé en ce que lesdits conducteurs à surveiller sont tels que le champ magnétique total créé sur la couche mince est nul lorsque les courants véhiculés sont nominaux.

7. Application du procédé selon l'une quelconque des revendications 3 à 6, à la surveillance de l'état de coupure éventuel des circuits d'alimentation des lampes électriques d'une voiture automobile, caractérisé en ce que lesdits circuits comportent des portions de conducteurs électriques groupés symétriquement au voisinage immédiat de quatre couches magnétiques minces orientées et placées selon les quatre branches d'un pont de Wheatstone équilibré en fonctionnement normal.

Office européen
des brevets

**RAPPORT DE RECHERCHE EUROPEENNE**

| Catégorie | Citation du document avec indication, en cas de besoin, des parties pertinentes | Revendica-tion concernée |
|---|---|---|
| **DOCUMENTS CONSIDERES COMME PERTINENTS** | | |
| A | US - A - 2 946 955 (F. KUHRT)<br>* Colonne 3, ligne 61 - colonne 4, ligne 16; figure 1 * | 1,5 |
| A | IBM TECHNICAL DISCLOSURE BULLETIN, vol. 18, no. 8, janvier 1976<br>NEW YORK (US)<br>K.H. KNICKMEYER: "Magnetoresistive detection apparatus", pages 2565-2566.<br>* En entier * | 1,2,7 |
| A | IBM TECHNICAL DISCLOSURE BULLETIN, vol. 18, no. 8, janvier 1976<br>NEW YORK (US)<br>C.H. BAJOREK et al.: "Magnetoresistive current sensor", pages 2745-2748.<br>* Page 2747, lignes 22-25; figure 4 * | 1-3,5, 7 |

**CLASSEMENT DE LA DEMANDE (Int. Cl. 3)**

G 01 R 15/02
G 01 R 31/02
B 60 Q 11/00
G 01 R 19/165

**DOMAINES TECHNIQUES RECHERCHES (Int. Cl. 3)**

G 01 R 31/02
      31/00
      19/16
      33/06
      15/02
B 60 Q 11/00
G 01 R 17/10

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 25-08-1980 | GALLO |

OEB Form 1503.1   06.78